# EUROPEAN PATENT APPLICATION

(11) **EP 4 632 809 A1**
(43) Date of publication of application: **15.10.2025**
(21) Application number: 25156017.3
(22) Date of filing: 05.02.2025
(51) Int. Cl.: H01L 23/498

(54) **SEMICONDUCTOR DEVICE WITH EMBEDDED FLEX SUBSTRATE AND METHOD THEREFOR**

(30) Priority: 12.04.2024 US 202418633596
(71) Applicant: NXP USA, Inc., Austin, TX 78735 (US)
(72) Inventor: Shah, Ankur Shailesh, 5656AG Eindhoven (NL); Vincent, Michael B, 5656AG Eindhoven (NL); Gong, Zhiwei, 5656AG Eindhoven (NL)
(74) Representative: Colaiuda, Antonella

(57) **Abstract**

A method of forming a semiconductor device is provided. The method includes interconnecting a semiconductor die and a flex substrate sub-assembly with a package substrate. The flex substrate sub-assembly includes a flexible conductive trace. A first portion of the flexible conductive trace is conductively connected to the package substrate. The method further includes encapsulating with an encapsulant at least a portion of the semiconductor die and the flex sub-assembly. A second portion of the flexible conductive trace is exposed at a top surface of the encapsulant.

## Description

### Background

### Field

This disclosure relates generally to semiconductor device packaging, and more specifically, to semiconductor devices with embedded flex substrate and method of forming the same.

### Related Art

Today, there is an increasing trend to include sophisticated semiconductor devices in products and systems that are used every day. These sophisticated semiconductor devices may include features for specific applications which may impact the configuration of the semiconductor device packages, for example. For some features and applications, the configuration of the semiconductor device packages may be susceptible to lower reliability, lower performance, and higher product or system costs. Accordingly, significant challenges exist in accommodating these features and applications while minimizing the impact on semiconductor devices' reliability, performance, and costs.

### Brief Description of the Drawings

The present invention is illustrated by way of example and is not limited by the accompanying figures, in which like references indicate similar elements. Elements in the figures are illustrated for simplicity and clarity and have not necessarily been drawn to scale.
FIG. 1 illustrates, in a simplified cross-sectional view, an example flex substrate sub-assembly at a stage of manufacture in accordance with an embodiment.
FIG. 2 illustrates, in a simplified cross-sectional view, an example semiconductor device sub-assembly at a stage of manufacture in accordance with an embodiment.
FIG. 3 through FIG. 5 illustrate, in simplified cross-sectional views, an example semiconductor device with the flex substrate sub-assembly at stages of manufacture in accordance with an embodiment.
FIG. 6 through FIG. 8 illustrate, in simplified cross-sectional views, alternative example semiconductor devices at a stage of manufacture in accordance with an embodiment.

### Detailed Description

Generally, there is provided, a semiconductor device with an embedded flex substrate. The semiconductor device includes a semiconductor die mounted on a package substrate and a flex substrate sub-assembly affixed to the backside of the semiconductor die. The flex substrate sub-assembly includes a plurality of patterned flexible conductive traces. Portions of the flexible conductive traces may be configured for attachment of one or more internal components of the semiconductor device. An interconnect region of the of the flexible conductive traces is connected to respective substrate contacts of the package substrate by way of a conductive material (e.g., solder, solder paste, glue). The semiconductor die, package substrate, and the flex substrate sub-assembly of the semiconductor device are at least partially encapsulated with an encapsulant. A top portion of the flexible conductive traces is exposed through the encapsulant and configured for attachment of one or more external components such as a packaged semiconductor device, semiconductor die, passive component, active components, battery, antenna, connection socket, and the like. A plurality of conductive connectors (e.g., solder balls) are conductively connected to conductive traces exposed at a bottom side of the package substrate and configured to provide conductive connections between the semiconductor device and a PCB. By forming the semiconductor device with the embedded in this manner, a more flexible, high density and cost-effective 3D interconnect can be realized.

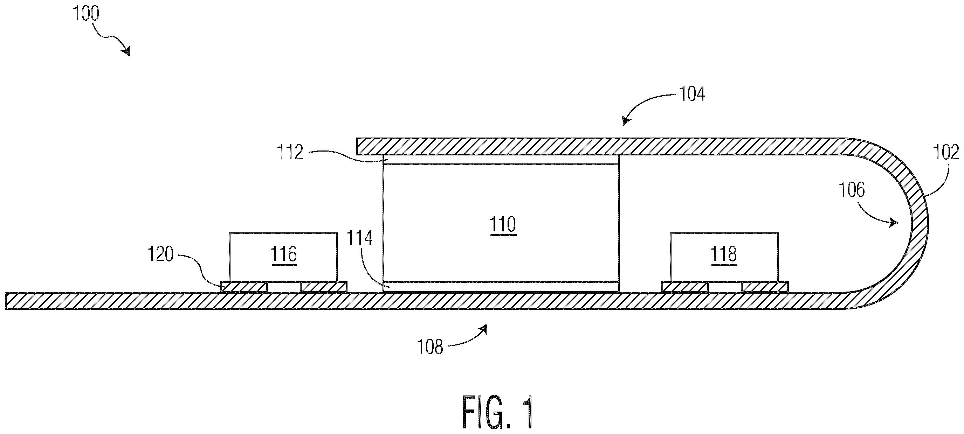

FIG. 1 illustrates, in a simplified cross-sectional view, an example flex substrate sub-assembly 100 of a semiconductor device at a stage of manufacture in accordance with an embodiment. At this stage of manufacture, the flex substrate sub-assembly 100 includes a plurality of flexible conductive traces 102, components 116 and 118, and spacer 110. In this embodiment, the plurality of the flexible conductive traces 102 is formed as a plurality of patterned conductive traces 102 on a flexible non-conductive layer (not shown). For example, the flexible conductive traces 102 may include patterned copper traces formed on a flexible polyimide layer. The term "conductive," as used herein, generally refers to electrical conductivity unless otherwise described.

In this embodiment, the flexible conductive traces 102 of the flex substrate sub-assembly 100 include a top planar portion 104, a bottom planar portion 108, and an intermediate portion 106 located between the top portion 104 and the bottom portion 108. One or more of the flexible conductive traces 102 are contiguous from a first end at the top portion 104, through the intermediate portion 106, and to a second end at the bottom portion 108. In this embodiment, the top portion 104 of the flexible conductive traces 102 is folded over the bottom portion 108 of the flexible conductive traces such that the top portion 104 overlaps the bottom portion 108. In this embodiment, the spacer 110 of the flex substrate sub-assembly 100 is disposed between the top portion 104 and the bottom portion 108 of the flexible conductive traces 102. The spacer 110 is affixed to a top surface of the bottom portion 108 by way of an adhesive (e.g., die attach film) 114. Likewise, the spacer 110 is affixed to a bottom surface of the top portion 104 by way of an adhesive 112. The spacer 110 may be formed from a rigid material (e.g., FR4, blank silicon die, the like) and configured to provide structural support for the top portion 104 of the flexible conductive traces 102. The top portion 104 of the flexible conductive traces 102 may be configured for attachment of an external component at a subsequent stage of manufacture, for example. In some embodiments, portions of the flexible conductive traces 102 may be configured as an antenna and/or a shield layer. It may be desirable for the coefficient of thermal expansion (CTE) of the spacer 110 to match the CTE of components (e.g., semiconductor die) of a semiconductor device, for example.

In this embodiment, the components 116 and 118 of the flex substrate sub-assembly 100 are mounted on the flexible conductive traces 102 and conductively connected to respective traces of the plurality of flexible conductive traces 102. Terminals (not shown) of the components 116 and 118 are attached to the respective traces by way of solder, solder paste, or conductive adhesive, for example. The components 116 and 118 may be characterized as one or more of the following or combinations thereof: semiconductor die, passive components (e.g., resistor, capacitor, inductor), active components (e.g., diode, transistor), and the like. The height of the spacer 110 may be chosen such that the components 116 and 118 may be located in the gap between the top portion 104 and bottom portion 108 of the flexible conductive traces 102. It should be understood that the configuration of the flexible conductive traces 102, the size and shape of the spacer 110, and the arrangement and number of components 116 and 118 of the flex substrate sub-assembly 100 shown in FIG. 1 are for illustrative purposes.

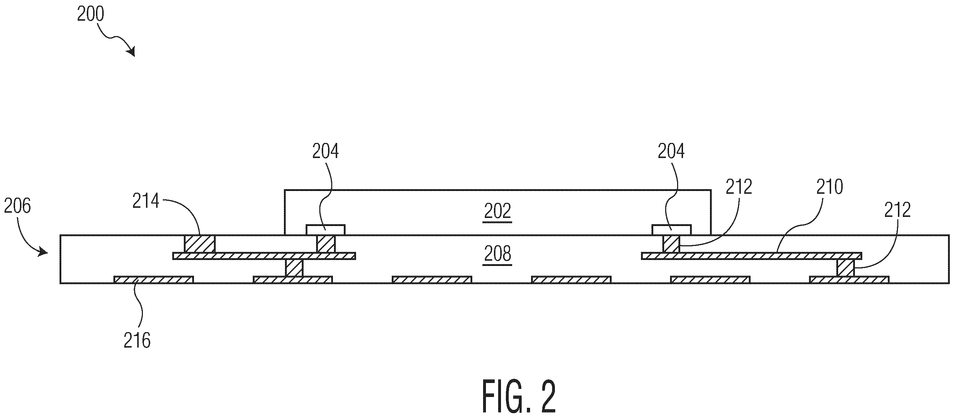

FIG. 2 illustrates, in a simplified cross-sectional view, an example semiconductor device sub-assembly 200 at a stage of manufacture in accordance with an embodiment. At this stage of manufacture, the semiconductor device sub-assembly 200 includes a semiconductor die 202 interconnected with a package substrate 206. In this embodiment, the package substrate 206 is provided as a pre-formed package substrate. The package substrate 206 includes conductive features (e.g., patterned copper traces 210 and 216, vias 212 and 214) surrounded by non-conductive material 208 (e.g., dielectric). The package substrate 206 may be characterized as a redistribution layer (RDL) substrate having exposed portions of vias 212 and 214 at a top surface and exposed portions of traces 216 at a bottom surface, for example. In this embodiment, the exposed portions of the vias 212 are configured for attachment of the semiconductor die 202 and the exposed portion of the vias 214 are configured for attachment of the flexible conductive traces 102 of FIG. 1 at a subsequent stage of manufacture. Detailed features of the package substrate 206 such as conductive connection pads at the top side and under-bump structures and solder mask layer at the bottom side are not shown for illustration purposes.

In some embodiments, the package substrate 206 may be formed as a build-up substrate at a subsequent stage of manufacture. For example, after a packaging encapsulation operation, bond pads of the semiconductor die may be exposed (e.g., by way of molding with a temporary film or carrier, etch, laser ablation, or other suitable process) allowing for conductive features of the package substrate to be interconnected with the bond pads 204 in a build-up manner.

The semiconductor die 202 has an active side (e.g., major side having circuitry) and a backside (e.g., major side opposite of the active side). The semiconductor die 202 includes bond pads 204 formed at the active side. The bond pads 204 are conductively connected to the exposed portions of vias 212 at the top surface of the package substrate 206 by way of solder, solder paste, or conductive adhesive, for example. In this embodiment, semiconductor die 202 is configured in an active-side-down orientation with the active side placed affixed to the package substrate 206. The semiconductor die 202 may be formed from any suitable semiconductor material, such as silicon, germanium, gallium arsenide, gallium nitride, and the like. The semiconductor die 202 may further include any digital circuits, analog circuits, RF circuits, power circuits, memory, processor, the like, and combinations thereof at the active side. Even though the semiconductor die 202 of FIG. 2 is depicted in an active-side-down orientation configuration, embodiments with other semiconductor die configurations such as active-side-up and wire-bonded are anticipated by this disclosure.

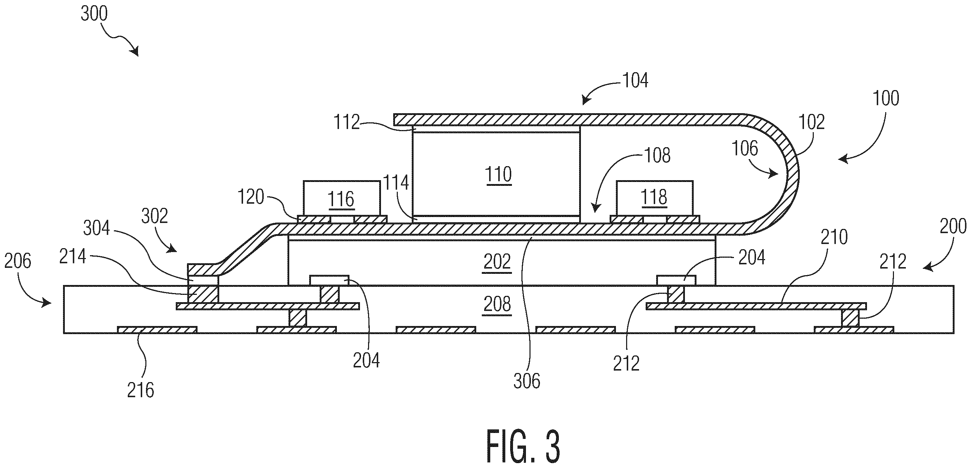

FIG. 3 through FIG. 5 illustrate, in simplified cross-sectional views, an example semiconductor device 300 including the flex substrate sub-assembly 100 of FIG. 1 joined with the device sub-assembly 200 of FIG. 2 at stages of manufacture in accordance with an embodiment.

FIG. 3 illustrates, in a simplified cross-sectional view, the example semiconductor device 300 at a subsequent stage of manufacture in accordance with an embodiment. At this stage, the semiconductor device 300 includes the flex substrate sub-assembly 100 attached and conductively connected to the device sub-assembly 200. In this embodiment, a bottom surface of the bottom portion 108 of the flex substrate sub-assembly 100 is affixed to the backside of the semiconductor die 202 by way of a die attach material 306. The die attach material 306 may be in the form of a paste, film (e.g., die attach film, DAF), or other suitable die attach material. An interconnect region 302 of the of the flexible conductive traces 102 is formed (e.g., bent) such that conductive traces 102 of the flex substrate sub-assembly 100 may be conductively connected to substrate contacts (e.g., exposed vias) 214 of the package substrate 206 by way of a conductive material 304 such as a conductive adhesive, paste, solder, and the like.

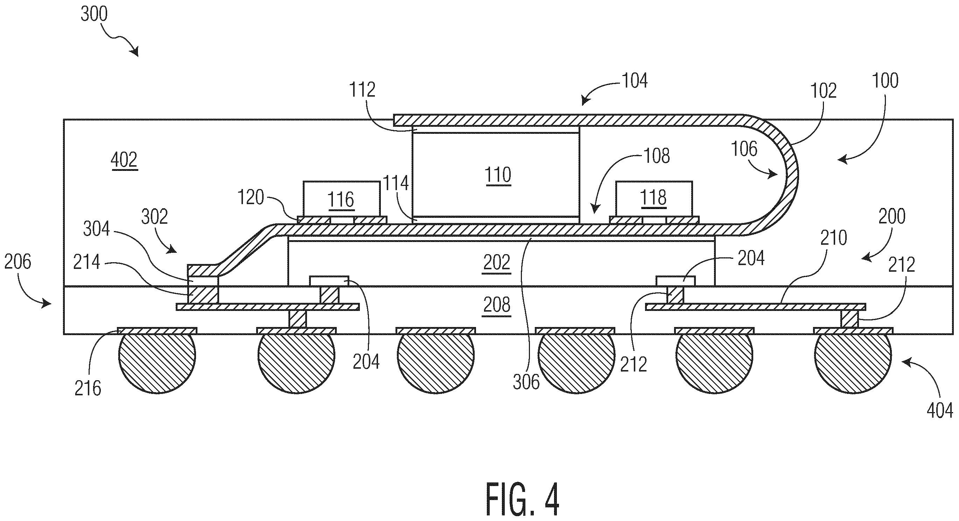

FIG. 4 illustrates, in a simplified cross-sectional view, the example semiconductor device 300 at a subsequent stage of manufacture in accordance with an embodiment. At this stage, the semiconductor device 300 includes the flex substrate sub-assembly 100 and the device sub-assembly 200 at least partially encapsulated with an encapsulant 402. In this embodiment, the flex substrate sub-assembly 100 and the device sub-assembly 200 are over-molded with the encapsulant 402 by way of a molding process. The encapsulant 402 may be an epoxy molding compound dispensed during an injection molding encapsulation operation, for example. Alternatively, the flex substrate sub-assembly 100 and the device sub-assembly 200 may be molded with the encapsulant 402 by way of a film-assisted molding (FAM) process. In this embodiment, the top portion 104 of the flex substrate sub-assembly 100 is exposed through the encapsulant 402. The exposed top portion 104 of the patterned conductive traces 102 is configured for attachment of one or more external components at a subsequent stage of manufacture. The one or more external components may be characterized as including one or more of the following or combinations thereof: packaged semiconductor device, semiconductor die, passive components (e.g., resistor, capacitor, inductor), active components (e.g., diode, transistor), batteries, antennas, connection sockets, and the like.

After the flex substrate sub-assembly 100 and the device sub-assembly 200 are encapsulated with an encapsulant 402, conductive connectors 404 (e.g., solder balls) are affixed to a bottom side of the package substrate 206. The conductive connectors 404 are conductively connected to exposed portions of conductive traces 216 at the bottom side of the package substrate 206. The conductive connectors 404 are configured and arranged to provide conductive connections between the semiconductor device 300 and a PCB, for example. The conductive connectors 404 may be in the form of suitable conductive structures such as solder balls, gold studs, copper pillars, and the like, to connect conductive features of the semiconductor device 300 with the PCB. As an alternative to attaching conductive connectors 404, the exposed portions of conductive traces 216 may be plated for subsequent connection with the PCB by way of solder paste attachment or other suitable conductive attachment processes (e.g., ACF, ACP).

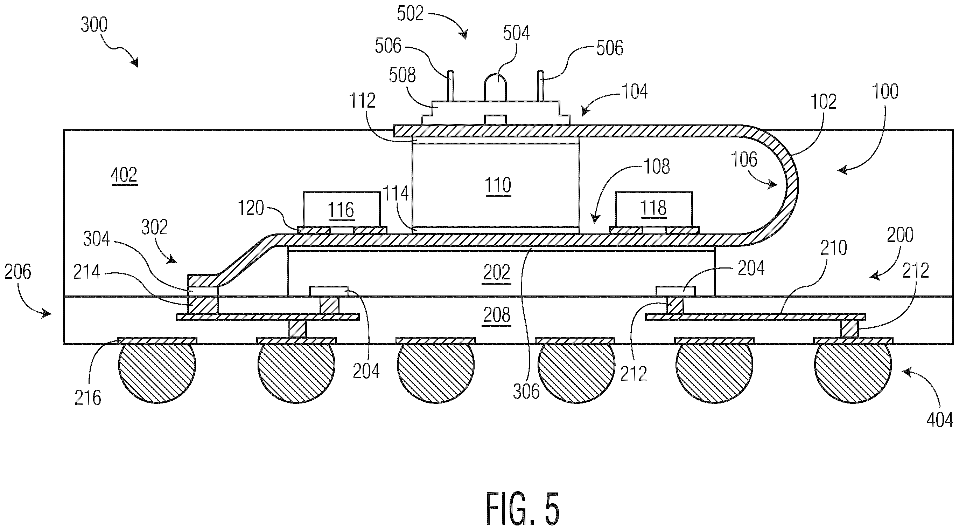

FIG. 5 illustrates, in a simplified cross-sectional view, the example semiconductor device 300 at a subsequent stage of manufacture in accordance with an embodiment. At this stage, the semiconductor device 300 includes a connector structure 502 affixed on the exposed top portion 104 of the flex substrate sub-assembly 100. The connector structure 502 includes a base 508, a conductive signal member 504, and a conductive shield member 506 surrounding the signal member 504. In this embodiment, the signal member 504 and the shield member 506 are conductively connected to the exposed top portion 104 of the patterned conductive traces 102. The signal member 504 may be interconnected to the semiconductor die 202 and/or the conductive connectors 404 by way of the flexible conductive traces 102 of the flex substrate sub-assembly 100 and conductive features of the package substrate 206 in this embodiment. It may be desirable to connect the shield member 506 to a ground voltage supply terminal to provide proper shielding of the signal member 504.

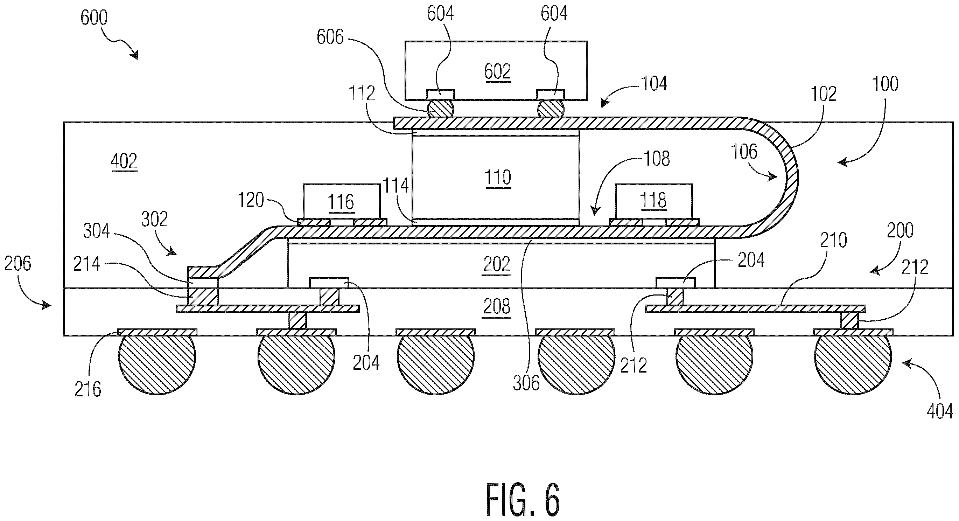

FIG. 6 illustrates, in a simplified cross-sectional view, an alternative example semiconductor device 600 at a stage of manufacture in accordance with an embodiment. In this embodiment, the stages of manufacture depicted in FIG. 1 through FIG. 4 remain similar with the flex substrate sub-assembly 100 and the device sub-assembly 200 at least partially encapsulated with an encapsulant 402. At this stage, the semiconductor device 600 includes an external component 602 affixed on the exposed top portion 104 of the flex substrate sub-assembly 100. The external component 602 includes a plurality of connection pads 604. In this embodiment, the connection pads 604 of the external component 602 are conductively connected to the exposed top portion 104 of the patterned conductive traces 102 by way of by way of conductive component connectors 606, for example. The conductive component connectors 606 may be in the form of suitable conductive structures such as gold studs, copper pillars, solder balls, and the like. The external component 602 may be characterized as a packaged semiconductor device, semiconductor die, passive component, active component, battery, antenna, and the like. In this embodiment, the external component 602 may be interconnected with the semiconductor die 202 and/or the conductive connectors 404 by way of the flexible conductive traces 102 of the flex substrate sub-assembly 100 and conductive features of the package substrate 206.

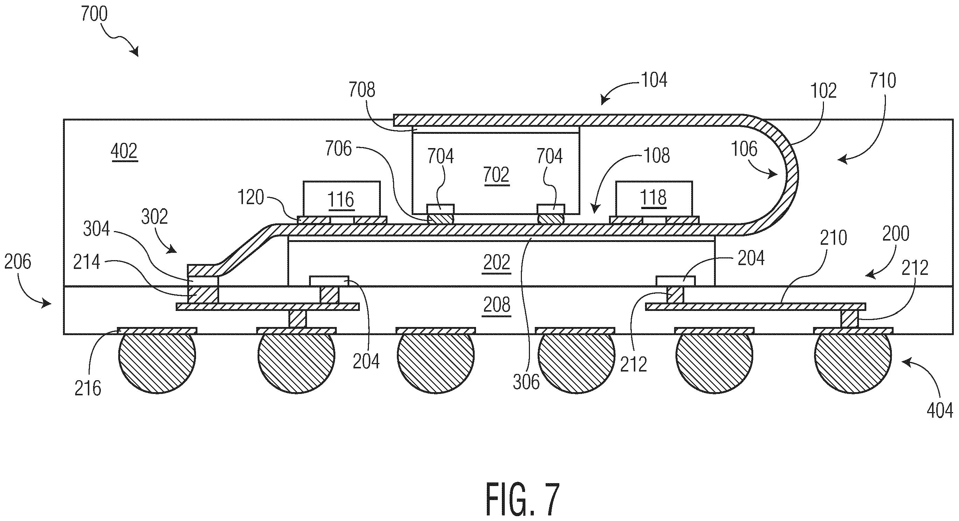

FIG. 7 illustrates, in a simplified cross-sectional view, an alternative example semiconductor device 700 at a stage of manufacture in accordance with an embodiment. In this embodiment, the stages of manufacture depicted in FIG. 2 through FIG. 4 remain similar including a flex substrate sub-assembly 710 as an alternative to the flex substrate sub-assembly 100 of FIG. 1. In this embodiment, the flex substrate sub-assembly 710 includes the plurality of flexible conductive traces 102 and components 116 and 118 as depicted in FIG. 1. The flexible conductive traces 102 of the flex substrate sub-assembly 710 include the top planar portion 104, the bottom planar portion 108, and the intermediate portion 106 located between the top portion 104 and the bottom portion 108 as depicted in FIG. 1.

In this embodiment, a semiconductor die 702 affixed to the flexible conductive traces 102 as an alternative to the spacer 110 of FIG. 1. Bond pads 704 of the semiconductor die 702 are conductively connected to the bottom planar portion 108 of the conductive traces 102 by way of by way of solder, solder paste, or conductive adhesive 706, for example. The semiconductor die 702 is affixed to the bottom surface of the top portion 104 conductive traces 102 by way of an adhesive 708. In this embodiment, the semiconductor die 702 may be further configured to serve as a spacer between the top portion 104 and the bottom portion 108 of the flex substrate sub-assembly 710. At this stage, the top portion 104 of the flex substrate sub-assembly 710 is exposed through the encapsulant 402. The exposed top portion 104 of the patterned conductive traces 102 is configured for attachment of one or more external components at a subsequent stage of manufacture.

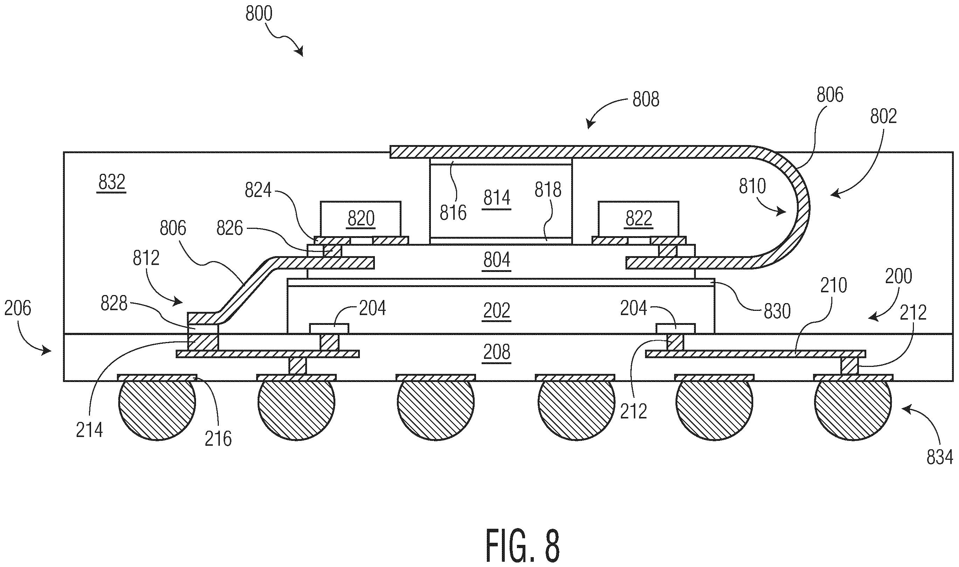

FIG. 8 illustrates, in a simplified cross-sectional view, an alternative example semiconductor device 800 at a stage of manufacture in accordance with an embodiment. In this embodiment, the stages of manufacture depicted in FIG. 2 through FIG. 4 remain similar including a rigid-flex substrate sub-assembly 802 as an alternative to the flex substrate sub-assembly 100 of FIG. 1. At this stage of manufacture, the rigid-flex substrate sub-assembly 802 includes a rigid portion 804, a plurality of flexible conductive traces 806, components 820 and 822, and spacer 814. In this embodiment, the rigid portion 804 is formed from rigid core materials (e.g., non-conductive core FR4 layer sandwiched between non-conductive epoxy prepreg layers) and the flex portion 806 is formed as patterned conductive (e.g., copper) traces 806 on a flexible non-conductive layer such as polyimide (not shown). In this embodiment, a portion of the conductive traces 806 is embedded in the rigid portion 804.

The flexible conductive traces 806 of the rigid-flex substrate sub-assembly 802 include a top planar portion 808 and an intermediate portion 810 located between the top portion 808 and the rigid portion 804. In this embodiment, the top portion 808 of the flexible conductive traces 806 is folded over the rigid portion 804 such that the top portion 808 overlaps the rigid portion 804. The spacer 814 is disposed between the top portion 808 and the rigid portion 804 of the flexible conductive traces 806. The spacer 814 is affixed to a bottom surface of the top portion 808 by way of an adhesive (e.g., paste, film, DAF) 816 and affixed to a top surface of the rigid portion 804 by way of an adhesive 818. In this embodiment, a bottom surface of the rigid portion 804 of the rigid-flex substrate sub-assembly 802 is affixed to the backside of the semiconductor die 202 of the device sub-assembly 200 by way of a die attach material (e.g., paste, film, DAF) 830. An interconnect region 812 of the of the flexible conductive traces 806 is configured (e.g., formed, bent) and connected to substrate contacts (e.g., exposed vias) 214 of the package substrate 206 by way of a conductive material 828 such as a conductive adhesive, paste, solder, and the like.

At this stage, the semiconductor device 800 includes the rigid-flex substrate sub-assembly 802 and the device sub-assembly 200 at least partially encapsulated with an encapsulant (e.g., epoxy molding compound) 832. In this embodiment, the top portion 808 of the rigid-flex substrate sub-assembly 802 is exposed through the encapsulant 832. The exposed top portion 808 of the patterned conductive traces 806 is configured for attachment of one or more external components at a subsequent stage of manufacture, for example. After the rigid-flex substrate sub-assembly 802 and the device sub-assembly 200 are encapsulated with an encapsulant 832, conductive connectors 834 (e.g., solder balls) are affixed to a bottom side of the package substrate 206. The conductive connectors 834 are conductively connected to exposed portions of conductive traces 216 at the bottom side of the package substrate 206. The conductive connectors 834 may be in the form of suitable conductive structures such as solder balls, gold studs, copper pillars, and the like, to connect conductive features of the semiconductor device 800 with a PCB, for example.

Generally, there is provided, a method including interconnecting a semiconductor die with a package substrate; interconnecting a flex substrate sub-assembly with the package substrate, the flex substrate sub-assembly comprising: a flexible conductive trace, a first portion of the flexible conductive trace conductively connected to the package substrate; and encapsulating with an encapsulant at least a portion of the semiconductor die and the flex sub-assembly, a second portion of the flexible conductive trace exposed at a top surface of the encapsulant. The exposed second portion of the flexible conductive trace may be configured for attachment of an external component. The flexible conductive trace may be interconnected with the semiconductor die by way of the package substrate. A third portion of the flexible conductive trace may be affixed to a backside of the semiconductor die, the third portion located between the first portion and the second portion of the flexible conductive trace. The flex substrate sub-assembly may further include a spacer disposed between the second portion of the flexible conductive trace and a backside of the semiconductor die. The flex substrate sub-assembly may further include a second semiconductor die conductively connected to the flexible conductive trace. The method may further include conductively connecting an external component to the exposed second portion of the flexible conductive trace, wherein the external component is characterized as one of a connector, semiconductor device, antenna, and battery. The external component may be interconnected with the semiconductor die by way of the flexible conductive trace. The flex substrate sub-assembly may further include a rigid substrate, a portion of the flexible conductive trace between the first portion and the second portion embedded in the rigid substrate.

In another embodiment, there is provided, a semiconductor device including a package substrate; a semiconductor die having an active side and a backside opposite of the active side, bond pads at the active side interconnected with the package substrate; a flex substrate sub-assembly interconnected with the package substrate, the flex substrate sub-assembly comprising: a flexible conductive trace, a first portion of the flexible conductive trace conductively connected to the package substrate; and an encapsulant encapsulating at least a portion of the semiconductor die and the flex sub-assembly, a second portion of the flexible conductive trace exposed at a top surface of the encapsulant and configured for attachment of an external component. A third portion of the flexible conductive trace may be affixed to a backside of the semiconductor die, the third portion located between the first portion and the second portion of the flexible conductive trace. The flex substrate sub-assembly may further include a spacer disposed between the second portion of the flexible conductive trace and a backside of the semiconductor die. The flexible conductive trace may be interconnected with the semiconductor die by way of the package substrate. The semiconductor device may further include an external component conductively connected to the exposed second portion of the flexible conductive trace. The external component may be interconnected with the semiconductor die by way of the flexible conductive trace.

In yet another embodiment, there is provided, a method including interconnecting bond pads of a semiconductor die with a package substrate; interconnecting a flex substrate sub-assembly with the package substrate, the flex substrate sub-assembly comprising: a flexible conductive trace, a first portion of the flexible conductive trace conductively connected to the package substrate; and encapsulating with an encapsulant at least a portion of the semiconductor die and the flex sub-assembly, a second portion of the flexible conductive trace exposed at a top surface of the encapsulant and configured for attachment of an external component. The flexible conductive trace may be interconnected with the semiconductor die by way of the package substrate. A third portion of the flexible conductive trace may be affixed to a backside of the semiconductor die, the third portion located between the first portion and the second portion of the flexible conductive trace. The second portion of the flexible conductive trace may be folded over the third portion of the flexible conductive trace such that the second portion overlaps the third portion of the flexible conductive trace and a backside of the semiconductor die. The method may further include conductively connecting an external component to the exposed second portion of the flexible conductive trace.

By now, it should be appreciated that there has been provided a semiconductor device with an embedded flex substrate. The semiconductor device includes a semiconductor die mounted on a package substrate and a flex substrate sub-assembly affixed to the backside of the semiconductor die. The flex substrate sub-assembly includes a plurality of patterned flexible conductive traces. Portions of the flexible conductive traces may be configured for attachment of one or more internal components of the semiconductor device. An interconnect region of the of the flexible conductive traces is connected to respective substrate contacts of the package substrate by way of a conductive material. The semiconductor die, package substrate, and the flex substrate sub-assembly of the semiconductor device are at least partially encapsulated with an encapsulant. A top portion of the flexible conductive traces is exposed through the encapsulant and configured for attachment of one or more external components such as a packaged semiconductor device, semiconductor die, passive component, active components, battery, antenna, connection socket, and the like. A plurality of conductive connectors (e.g., solder balls) are conductively connected to conductive traces exposed at a bottom side of the package substrate and configured to provide conductive connections between the semiconductor device and a PCB. By forming the semiconductor device with the embedded in this manner, a more flexible, high density and cost-effective 3D interconnect can be realized.

The terms "front," "back," "top," "bottom," "over," "under" and the like in the description and in the claims, if any, are used for descriptive purposes and not necessarily for describing permanent relative positions. It is understood that the terms so used are interchangeable under appropriate circumstances such that the embodiments of the invention described herein are, for example, capable of operation in other orientations than those illustrated or otherwise described herein.

Although the invention is described herein with reference to specific embodiments, various modifications and changes can be made without departing from the scope of the present invention as set forth in the claims below. Accordingly, the specification and figures are to be regarded in an illustrative rather than a restrictive sense, and all such modifications are intended to be included within the scope of the present invention. Any benefits, advantages, or solutions to problems that are described herein with regard to specific embodiments are not intended to be construed as a critical, required, or essential feature or element of any or all the claims.

Furthermore, the terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles.

Unless stated otherwise, terms such as "first" and "second" are used to arbitrarily distinguish between the elements such terms describe. Thus, these terms are not necessarily intended to indicate temporal or other prioritization of such elements.

## Claims

1. A method comprising:
interconnecting a semiconductor die with a package substrate;
interconnecting a flex substrate sub-assembly with the package substrate, the flex substrate sub-assembly comprising:
a flexible conductive trace, a first portion of the flexible conductive trace conductively connected to the package substrate; and
encapsulating with an encapsulant at least a portion of the semiconductor die and the flex sub-assembly, a second portion of the flexible conductive trace exposed at a top surface of the encapsulant.

2. The method of claim 1, wherein the exposed second portion of the flexible conductive trace is configured for attachment of an external component.

3. The method of claim 1 or claim 2, wherein the flexible conductive trace is interconnected with the semiconductor die by way of the package substrate.

4. The method according to any preceding claim, wherein a third portion of the flexible conductive trace is affixed to a backside of the semiconductor die, the third portion located between the first portion and the second portion of the flexible conductive trace.

5. The method according to any preceding claim, wherein the flex substrate sub-assembly further comprises a spacer disposed between the second portion of the flexible conductive trace and a backside of the semiconductor die.

6. The method according to any preceding claim, wherein the flex substrate sub-assembly further comprises a second semiconductor die conductively connected to the flexible conductive trace.

7. The method according to any preceding claim, further comprising conductively connecting an external component to the exposed second portion of the flexible conductive trace, wherein the external component is characterized as one of a connector, semiconductor device, antenna, and battery.

8. The method of claim 7, wherein the external component is interconnected with the semiconductor die by way of the flexible conductive trace.

9. The method according to any preceding claim, wherein the flex substrate sub-assembly further comprises a rigid substrate, a portion of the flexible conductive trace between the first portion and the second portion embedded in the rigid substrate.

10. A semiconductor device comprising:
a package substrate;
a semiconductor die having an active side and a backside opposite of the active side, bond pads at the active side interconnected with the package substrate;
a flex substrate sub-assembly interconnected with the package substrate, the flex substrate sub-assembly comprising:
a flexible conductive trace, a first portion of the flexible conductive trace conductively connected to the package substrate; and
an encapsulant encapsulating at least a portion of the semiconductor die and the flex sub-assembly, a second portion of the flexible conductive trace exposed at a top surface of the encapsulant and configured for attachment of an external component.

11. The semiconductor device of claim 10, wherein a third portion of the flexible conductive trace is affixed to a backside of the semiconductor die, the third portion located between the first portion and the second portion of the flexible conductive trace.

12. The semiconductor device of claim 10 or claim 11, wherein the flex substrate sub-assembly further comprises a spacer disposed between the second portion of the flexible conductive trace and a backside of the semiconductor die.

13. The semiconductor device according to claims 10 to 12, wherein the flexible conductive trace is interconnected with the semiconductor die by way of the package substrate.

14. The semiconductor device according to claims 10 to 13, further comprising an external component conductively connected to the exposed second portion of the flexible conductive trace.

15. The semiconductor device of claim 14, wherein the external component is interconnected with the semiconductor die by way of the flexible conductive trace.
